Europäisches Patentamt

European Patent Office

Office européen des brevets

(19)

(11) **EP 1 342 525 A1**

(12) **EUROPÄISCHE PATENTANMELDUNG**

(43) Veröffentlichungstag:
**10.09.2003 Patentblatt 2003/37**

(51) Int Cl.⁷: **B23K 3/06**, B23K 3/00,
B23K 1/012

(21) Anmeldenummer: **02005422.7**

(22) Anmeldetag: **08.03.2002**

(84) Benannte Vertragsstaaten:
**AT BE CH CY DE DK ES FI FR GB GR IE IT LI LU
MC NL PT SE TR**
Benannte Erstreckungsstaaten:
**AL LT LV MK RO SI**

(71) Anmelder: **ESEC Trading SA**
**6330 Cham (CH)**

(72) Erfinder:
• **Suter, Guido**
**6312 Steinhausen (CH)**
• **Tschudin, Christoph**
**8055 Zürich (CH)**

(74) Vertreter: **Falk, Urs, Dr.**
**Patentanwaltsbüro Dr. Urs Falk,**
**Eichholzweg 9A**
**6312 Steinhausen (CH)**

(54) **Verfahren und Einrichtung zum Auftragen von Lot auf ein Substrat**

(57)     Zum Auftragen von Lot auf ein Substrat (1) werden einer Mischkammer (6) einer Zweistoffdüse (4) ein Lotdraht (7) und auf eine vorbestimmte Temperatur erhitztes Formiergas zugeführt, so dass in der Mischkammer (6) Lot abgeschmolzen und im Gasstrom mitgeführt wird. Das aus der Zweistoffdüse (4) herausgeblasene Lot setzt sich auf dem Substrat (1) ab. Die Zweistoffdüse (4) wird relativ zum Substrat (1) bewegt oder verschwenkt, um das Lot auf einer vorbestimmten Fläche des Substrats (1) zu verteilen.

Fig. 1

**Beschreibung**

Die Erfindung betrifft ein Verfahren und eine Einrichtung zum Auftragen von Lot auf ein Substrat der im Oberbegriff des Anspruchs 1 genannten Art.

Lötverfahren dieser Art werden typischerweise - jedoch nicht ausschliesslich - bei der Montage von Halbleiterchips auf einem metallischen Substrat, einem sogenannten Leadframe, angewendet. Hauptsächlich Leistungshalbleiter werden in der Regel mit dem Substrat, das üblicherweise aus Kupfer besteht, mittels Weichlötung verbunden, um über die Lötverbindung eine im Vergleich zur Montage mittels Klebstoff wirksamere Ableitung der beim Betrieb entstehenden Verlustwärme aus dem Halbleiterchip zu gewährleisten. Allerdings werden, vor allem bei gesteigerter Leistungsdichte, hohe Anforderungen an die Homogenität der Lötverbindung gestellt, d.h. es werden definierte Dicke, gleichmässige Verteilung und einwandfreie Benetzung der Lotschicht über die ganze Chipfläche, bzw. völlige Blasenfreiheit sowie Reinheit der Lötstelle verlangt; andererseits soll aber das Lot möglichst nicht aus dem Lotspalt seitlich austreten und sich neben dem Chip ausbreiten, was wiederum eine genaue Dosierung und Positionierung der Lotportionen erfordert.

Im Anwendungsbereich der Chip-Montage ist ein Verfahren im praktischen Einsatz weit verbreitet, bei dem das Ende eines Lötmetall-Drahtes mit dem über die Schmelztemperatur des Lotes erhitzten Substrat in Berührung gebracht wird, um ein Stück des Drahtes abzuschmelzen. Dieses Verfahren ist aufgrund seiner Einfachheit und Flexibilität für die Massenproduktion an sich gut geeignet. Jedoch hängt der Schmelzvorgang, vor allem das Volumen und die Positionierung der Lotportion, sehr stark von der Materialpaarung und den Oberflächeneigenschaften des Substrats ab, d.h. die Menge und Position des jeweils abschmelzenden Lotes sind erheblichen Streuungen unterworfen. Zudem ist die entstehende, etwa kreisförmige Benetzungsfläche schlecht an die rechteckige oder quadratische Gestalt der Chips angepasst. Aus der US 6 056 184 ist zudem ein Formstempel bekannt, mit dem die auf dem Substrat deponierte Lotportion in eine flache, der rechteckigen Gestalt der Chips angepasste Form gebracht werden kann.

Aus der US 5 878 939 ist ein Verfahren bekannt, bei dem flüssiges Lot in eine zwischen einem Formstempel und dem Substrat gebildete Kavität gespritzt wird.

Diese bekannten Verfahren haben einige Nachteile. Die Form des deponierten Lotes ist entweder rund oder es muss für jede rechteckförmige Form ein spezifischer Formstempel hergestellt werden. Ein solcher Formstempel hat Seitenwände, die einen Teil des Substrates belegen. Das Lot kann somit nicht bis zum Rand der den Halbleiterchip aufnehmenden Chipinsel aufgebracht werden. Zudem muss das Substrat über die Schmelztemperatur des Lotes aufgeheizt werden und das deponierte Lot muss vom Auftragen bis zum Aufbringen des Halbleiterchips in flüssiger Form gehalten werden. Nachteilig ist auch, dass die mit dem flüssigen Lot in Berührung kommenden Teile regelmässig gereinigt werden müssen, wozu die Produktion unterbrochen werden muss.

Aus den US 4 577 398 und US 4 709 849 ist ein Verfahren bekannt, bei dem flache Formlinge aus Lötmetall, sogenannte "solder preforms", deren Abmessungen auf die Chips abgestimmt sind, vorfabriziert werden. Die Lot-Formlinge werden dann auf das Substrat aufgelegt und von diesem aufgeschmolzen, um eine Lotschicht in den verlangten Dimensionen zu bilden. Wegen der erforderlichen Vorfabrikation der Lot-Formlinge und den zusätzlichen Montageoperationen ist diese Methode allerdings recht kostspielig und wenig flexibel.

Der Erfindung liegt die Aufgabe zugrunde, ein Verfahren für das Auftragen von Lot auf ein Substrat zu entwickeln, das die genannten Nachteile nicht mehr aufweist.

Die Erfindung besteht in den im Anspruch 1 angegebenen Merkmalen.

Das erfindungsgemässe Verfahren zum Auftragen von Lot auf ein Substrat zeichnet sich dadurch aus, dass einer Mischkammer einer Zweistoffdüse ein Lotdraht und auf eine vorbestimmte Temperatur erhitztes Formiergas zugeführt werden, so dass in der Mischkammer Lot abgeschmolzen und im Gasstrom mitgeführt wird. Das aus der Zweistoffdüse herausgeblasene Lot setzt sich auf dem Substrat ab. Die Zweistoffdüse wird relativ zum Substrat bewegt oder verschwenkt, um das herausgeblasene Lot auf der vorbestimmten Fläche der Chipinsel zu deponieren. Der Lotdraht wird bevorzugt in einem gekühlten Führungsrohr zur Mischkammer geführt. Zum Unterbrechen des Abschmelzens von Lot wird bevorzugt der Lotdraht zurückgezogen, so dass sich das Ende des Lotdrahtes innerhalb des Führungsrohres befindet.

Die Erfindung ermöglicht das berührungslose Auftragen von Lot auf ein Substrat, so dass auf dem Substrat keine Kratzer entstehen können. Zudem ist das Muster des deponierten Lots frei programmierbar und es kann Lot bis an den Rand der Chipinsel aufgetragen werden. Das Lot kann deponiert werden, ohne dass das Substrat auf die Schmelztemperatur des Lotes aufgeheizt werden muss. Die Verteilung des deponierten Lots auf dem Substrat kann deshalb mit einer Kamera kontrolliert werden, ohne dass hitzebedingte Schlieren das Bild trüben oder verzerren.

Nachfolgend werden Ausführungsbeispiele der Erfindung anhand der nicht massstäblich gezeichneten Figuren näher erläutert.

Es zeigen:

Fig. 1    eine Einrichtung zum Auftragen von Lot auf ein Substrat mit einer Zweistoffdüse,

Fig. 2    ein erstes Ausführungsbeispiel der Zweistoffdüse, und

Fig. 3 ein zweites Ausführungsbeispiel der Zweistoffdüse.

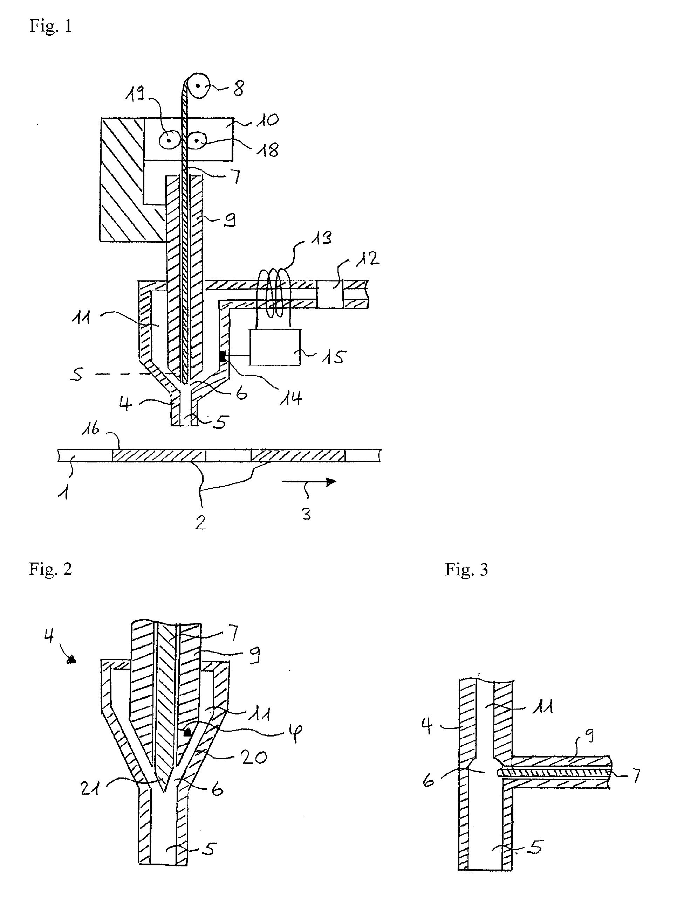

Die Fig. 1 zeigt eine Einrichtung zum Auftragen von Lot auf ein Substrat 1. Das Substrat 1 ist beispielsweise ein metallisches, streifenförmiges Substrat, ein sogenanntes Leadframe, mit mehreren Chipinseln 2 für die Aufnahme von Halbleiterchips, oder ein Einzelplatzsubstrat für die Aufnahme eines einzigen Halbleiterchips. Das Substrat 1 wird schrittweise in Richtung des Pfeils 3 transportiert. Die Einrichtung umfasst eine Zweistoffdüse 4 mit einem Ausgangskanal 5 und einer Mischkammer 6, der einerseits Lot in Form eines Lotdrahtes 7 und andererseits auf eine vorbestimmte Temperatur erhitztes Formiergas zugeführt wird. Die Mischkammer 6 kann auch einfach der Anfangsteil des Ausgangskanals 5 sein. Sie kennzeichnet den Bereich, in dem das heisse Formiergas Lot vom Lotdraht 7 abschmilzt. Das Formiergas ist vorzugsweise mit Wasserstoff $H_2$ angereicherter Stickstoff $N_2$. Der Wasserstoffanteil beträgt nur einige Prozent und dient dazu, allfällig vorhandenen Sauerstoff $O_2$ zu reduzieren. Der auf einer Spule 8 aufgewickelte Lotdraht 7 wird in einem Führungsrohr 9 zur Mischkammer 6 der Zweistoffdüse 4 geführt und mit Hilfe eines Antriebs 10 vorgeschoben. Das Formiergas wird der Mischkammer 6 über einen Gaskanal 11 zugeführt. Der Gaskanal 11 enthält ein Ventil 12 zur Regelung des Durchflusses und eine Heizung 13 zum Aufheizen des Formiergases auf eine vorbestimmte Temperatur. Die Temperatur des Formiergases wird mittels eines im Gaskanal 11 vor der Mischkammer 6 angebrachten Temperaturfühlers 14 gemessen. Der Temperaturfühler 14, die Heizung 13 und eine elektronische Schaltung 15 bilden in bekannter Weise einen Regelkreis zur Regelung der Temperatur des Formiergases. Wenn das aus dem Ausgangskanal 5 der Zweistoffdüse 4 ausströmende Formiergas auf das Substrat 1 auftrifft, dann setzt sich das im Formiergas mitgeführte Lot auf dem Substrat 1 ab.

Die Abmessungen der Austrittsöffnung der Zweistoffdüse 4 sind normalerweise kleiner als die Fläche 16, die die auf dem Substrat 1 deponierte Lotportion aufweisen soll. Während des Auftragens des Lotes auf das Substrat 1 muss der aus der Zweistoffdüse 4 ausströmende Gasstrahl deshalb in einer Schreibbewegung über die vorgesehene Fläche 16 hin und her geführt werden. Die Einrichtung weist deshalb Antriebsmittel 17 auf, um die Zweistoffdüse 4 entweder in zwei verschiedenen Richtungen parallel zur Oberfläche des Substrates 1 zu bewegen oder um zwei vorbestimmte, zur Oberfläche des Substrates 1 parallele Achsen zu schwenken.

Die Zuführung des Lotes muss für das Deponieren einer Lotportion auf dem Substrat 1 eingeschaltet und, für den Vorschub des Substrats 1 zur nächsten Chipinsel 2, unterbrochen werden können. Um Lot zu deponieren, wird deshalb der Lotdraht 7 mittels des Antriebs 10 mit vorbestimmter Geschwindigkeit vorgeschoben. Das in der Mischkammer 6 am Lotdraht 7 vorbeiströmende Formiergas schmilzt kontinuierlich Lot ab und deponiert es auf dem Substrat 1. Zum Stoppen des Abschmelzens von Lot in der Mischkammer 6 wird der Vorschub des Lotdrahtes 7 gestoppt. Vorzugsweise wird der Lotdraht 7 sogar mittels des Antriebs 10 um eine vorbestimmte Distanz D zurückgezogen. Die Zufuhr des Formiergases muss nicht unterbrochen werden.

Der Antrieb 10 für den Vorschub des Lotdrahtes 7 besteht vorzugsweise aus einem Schrittmotor, der ein Antriebsrad 18 antreibt und einem Andruckrad 19, das den Lotdraht 7 gegen das Antriebsrad 18 drückt. Das Andruckrad 19 ist mit einem Encoder versehen, über den der Vorschub wie auch die Rückwärtsbewegung des Lotdrahtes 7 kontrolliert wird.

Die auf dem Substrat 1 zu deponierende Lotmenge und die vom Lot zu belegende Fläche 16 sind prozessbedingte, vorgegebene Grössen. Auch die Zeit $\tau$, die zur Verfügung steht, um die Lotportion zu deponieren, ist in der Regel vorgegeben. Die Zeit $\tau$ beträgt typischerweise einige Hundert Millisekunden, z.B. 300 Millisekunden. Zunächst werden einige prozessrelevante Parameter ermittelt:

1. Aus der zu deponierenden Lotmenge $M_L$ und der Querschnittsfläche A des Lotdrahtes 7 wird die benötigte Drahtlänge L des Lotdrahtes 7 berechnet zu:

$$L = M_L/A.$$

2. Aus der Länge L und der zur Verfügung stehenden Zeit $\tau$ wird die Vorschubgeschwindigkeit v des Lotdrahtes berechnet zu:

$$v = L/\tau.$$

3. Aus der zu deponierenden Lotmenge $M_L$ und der zur Verfügung stehenden Zeit $\tau$ wird die benötigte Abscheidungsrate r des Lotes berechnet zu:

$$r = M_L/\tau.$$

4. Die Abscheidungsrate r ist eine Funktion der Temperatur T und der Durchflussrate $\Phi$ des Formiergases: $r = f(T, \Phi)$. Es werden nun eine Temperatur $T_P$ und eine Durchflussrate $\Phi_P$ ermittelt, die die Bedingung

$$M_L/\tau = f(T_P, \Phi_P)$$

erfüllen.

Die Temperatur $T_P$ des Formiergases muss oberhalb der Schmelztemperatur des Lotes liegen. Sie liegt typisch im Bereich von 400°C bis 600°C. Auch die Durchflussrate $\Phi_P$ sollte einen vorbestimmten Mindestwert überschreiten.

Bevorzugt wird das Führungsrohr 9 auf eine vorbestimmte Temperatur gekühlt. Dadurch verbessert sich die Stabilität des Prozesses, da das Abschmelzen des Lotdrahtes 7 unter kontrollierten Bedingungen erfolgt.

Zu Beginn des Produktionsbetriebs wird das Ventil 12 geöffnet und so eingestellt, dass die Durchflussrate des Formiergases den Wert $\Phi_P$ erreicht. Die Temperatur des Formiergases wird auf den Wert $T_P$ geregelt. Die Spitze des Lotdrahtes 7 befindet sich innerhalb des Führungsrohres 9 an einer vorbestimmten Stelle S. Die Zweistoffdüse 4 befindet sich in einer Ausgangsposition. Nachdem die erste Chipinsel 2 für das Auftragen des Lots bereitgestellt worden ist, wird das Lot gemäss dem folgenden Verfahren aufgetragen:

    1. Der Lotdraht 7 wird um eine vorbestimmte Distanz D vorgeschoben. Die Spitze des Lotdrahtes 7 befindet sich nun in der Mischkammer 6, so dass das vorbeiströmende Formiergas Lot abschmilzt und mitführt.

    2. Der Lotdraht 7 wird während der Zeitdauer $\tau$ mit der Geschwindigkeit v kontinuierlich vorgeschoben. Der aus der Zweistoffdüse 4 ausströmende Gasstrahl wird mittels der Antriebsmittel 17 über das Substrat 1 geführt, wobei er auf dem Substrat 1 eine kontinuierliche Linie deponierten Lots hinterlässt. Die Linie ist beispielsweise mäanderförmig. Die Schreibbewegung der Zweistoffdüse 4 mittels der Antriebsmittel 17 wird mit dem Beginn des Vorschubs des Lotdrahtes 7 synchronisiert und so gesteuert, dass die vorgegebene Linie innerhalb der zur Verfügung stehenden Zeit geschrieben wird.

    3. Nach Ablauf der Zeitdauer $\tau$ wird der Lotdraht 7 um die vorbestimmte Distanz D zurückgezogen.

Das Auftragen des Lots ist nun beendet. Die Zweistoffdüse 4 wird in ihre Ausgangsposition gebracht und die nächste Chipinsel wird bereitgestellt.

Vorzugsweise wird die Durchflussrate $\Phi_P$ des Formiergases bei der Verarbeitung verschiedener Produkte konstant gehalten, beispielsweise bei 200 Litern pro Stunde, und es wird im Schritt 4 jeweils die Temperatur T des Formiergases der benötigten Abscheidungsrate r angepasst.

Im folgenden werden zwei verschiedene Beispiele für die Ausführung der Zweistoffdüse 4 näher erläutert:

Beispiel 1

Die Fig. 2 zeigt eine Zweistoffdüse 4, bei der das Führungsrohr 9 und der Ausgangskanal 5 koaxial verlaufen, beispielsweise wie gezeigt in vertikaler Richtung. Der Gaskanal 11 verläuft koaxial zum Führungsrohr 9 und mündet am Ende des Führungsrohres 9 von allen Seiten unter einem durch eine Wand 20 des Gaskanals 11 definierten Einströmwinkel $\varphi$ in den Ausgangskanal 5. Bei diesem Beispiel ist die Mischkammer 6 ein Teil des Ausgangskanals 5. Sie ist definiert durch den oberen Bereich des Ausgangskanals 5, wo sich das Formiergas und das geschmolzene Lot mischen. Der Einströmwinkel $\varphi$ beeinflusst massgeblich die geometrische Form des Endes des Lotdrahtes 7. Wenn der Einströmwinkel $\varphi$ mehr als etwa 60° beträgt, dann ist das Ende des Lotdrahtes 7 kugelförmig. Wenn der Einströmwinkel $\varphi$, wie dargestellt, weniger als etwa 60° beträgt, dann ist das Ende des Lotdrahtes 7 hingegen kegelförmig. Die Länge des Kegels 21 hängt vom Winkel $\varphi$ ab. Wenn die Länge des Kegels 21 ein gewisses Mass überschreitet, dann kommt es immer wieder vor, dass ein Teil des Kegels 21 unkontrolliert abreisst. Der Querschnitt des Gaskanals 11 bestimmt die Geschwindigkeit des Formiergases beim Einströmen in den Ausgangskanal 5. Je kleiner der Querschnitt bei vorgegebener Durchflussrate $\Phi_P$ ist, desto grösser ist die Einströmgeschwindigkeit.

Beispiel 2

Bei diesem in der Fig. 3 dargestellten Beispiel sind der Gaskanal 11 und der Ausgangskanal 5 koaxial. Das Führungsrohr 9 für den Lotdraht 7 verläuft waagrecht, so dass der Lotdraht 7 seitlich in den Ausgangskanal 5 hineinragt. Die Querschnittsfläche des Gaskanals 11 ist kleiner als die Querschnittsfläche des Ausgangskanals 5: Beim Übergang vom Gaskanal 11 in den Ausgangskanal 5 erweitert sich der Querschnitt der Zweistoffdüse, und zwar unmittelbar oberhalb der Stelle, wo das Führungsrohr 9 in den Ausgangskanal 5 einmündet. Auch bei diesem Beispiel ist die Mischkammer 6 ein Teil des Ausgangskanals 5.

**Patentansprüche**

1.   Verfahren zum Auftragen von Lot auf ein Substrat (1), **dadurch gekennzeichnet, dass** einer Mischkammer (6) einer Zweistoffdüse (4) ein Lotdraht (7) und auf eine vorbestimmte Temperatur erhitztes Formiergas zugeführt werden, so dass in der Mischkammer (6) Lot abgeschmolzen und im Gasstrom mitgeführt wird, und dass die Zweistoffdüse (4) relativ zum Substrat (1) bewegt oder verschwenkt wird, wobei sich das aus der Zweistoffdüse (4) herausgeblasene Lot auf dem Substrat (1) absetzt.

2. Verfahren nach Anspruch 1, **dadurch gekennzeichnet, dass** der Lotdraht (7) in einem Führungsrohr (9) zur Mischkammer (6) geführt wird und dass der Lotdraht (7) zum Unterbrechen des Deponierens von Lot zurückgezogen wird, so dass sich das Ende des Lotdrahtes (7) innerhalb des Führungsrohres (9) befindet.

Fig. 1

Fig. 2

Fig. 3

**Europäisches Patentamt**

# EUROPÄISCHER RECHERCHENBERICHT

Nummer der Anmeldung

EP 02 00 5422

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| A | PATENT ABSTRACTS OF JAPAN vol. 2000, no. 26, 1. Juli 2002 (2002-07-01) & JP 2001 252762 A (JAPAN UNIX CO LTD), 18. September 2001 (2001-09-18) * Zusammenfassung * --- | 1,2 | B23K3/06 B23K3/00 B23K1/012 |
| A | PATENT ABSTRACTS OF JAPAN vol. 1998, no. 01, 30. Januar 1998 (1998-01-30) & JP 09 232746 A (OMRON CORP;SETA GIKEN:KK), 5. September 1997 (1997-09-05) * Zusammenfassung * --- | 1,2 | |
| A,D | US 5 878 939 A (SUTER GUIDO  ET AL) 9. März 1999 (1999-03-09) * das ganze Dokument * --- | 1,2 | |
| A | DE 37 34 550 A (UMMEN FRANZ) 27. April 1989 (1989-04-27) * Zusammenfassung * --- | 1,2 | |
| A | US 4 934 309 A (LEDERMANN PETER G  ET AL) 19. Juni 1990 (1990-06-19) * Spalte 8, Zeile 5 – Zeile 17; Abbildungen 6A,6B * --- | 1,2 | RECHERCHIERTE SACHGEBIETE (Int.Cl.7) B23K |
| A | DE 39 13 143 A (U T S UHRENTECHNIK SCHWARZWALD) 25. Oktober 1990 (1990-10-25) * Zusammenfassung * ----- | 1,2 | |

Der vorliegende Recherchenbericht wurde für alle Patentansprüche erstellt

| Recherchenort | Abschlußdatum der Recherche | Prüfer |
|---|---|---|
| MÜNCHEN | 25. Juli 2002 | De Backer, T |

EPO FORM 1503 03.82 (P04C03)

**ANHANG ZUM EUROPÄISCHEN RECHERCHENBERICHT
ÜBER DIE EUROPÄISCHE PATENTANMELDUNG NR.**   EP 02 00 5422

In diesem Anhang sind die Mitglieder der Patentfamilien der im obengenannten europäischen Recherchenbericht angeführten
Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

25-07-2002

| Im Recherchenbericht angeführtes Patentdokument | | | Datum der Veröffentlichung | Mitglied(er) der Patentfamilie | | Datum der Veröffentlichung |
|---|---|---|---|---|---|---|
| JP 2001252762 | A | | 18-09-2001 | KEINE | | |
| JP 09232746 | 2 | A | | KEINE | | |
| US 5878939 | A | | 09-03-1999 | DE | 59605457 D1 | 27-07-2000 |
| | | | | EP | 0752294 A2 | 08-01-1997 |
| | | | | EP | 0970774 A2 | 12-01-2000 |
| | | | | KR | 253995 B1 | 01-05-2000 |
| | | | | SG | 67355 A1 | 21-09-1999 |
| DE 3734550 | A | | 27-04-1989 | DE | 3734550 A1 | 27-04-1989 |
| | | | | WO | 8903272 A1 | 20-04-1989 |
| | | | | EP | 0351419 A1 | 24-01-1990 |
| US 4934309 | A | | 19-06-1990 | US | 4898117 A | 06-02-1990 |
| | | | | DE | 68901573 D1 | 25-06-1992 |
| | | | | EP | 0337149 A2 | 18-10-1989 |
| | | | | JP | 1958784 C | 10-08-1995 |
| | | | | JP | 2015698 A | 19-01-1990 |
| | | | | JP | 6093543 B | 16-11-1994 |
| DE 3913143 | A | | 25-10-1990 | DE | 3913143 A1 | 25-10-1990 |

EPO FORM P0461

Für nähere Einzelheiten zu diesem Anhang : siehe Amtsblatt des Europäischen Patentamts, Nr. 12/82